# FASCICULE DE BREVET EUROPEEN

(11) **EP 1 540 739 B1**
(45) Date de publication et mention de la délivrance du brevet: **07.11.2007**
(21) Numéro de dépôt: 03773773.1
(22) Date de dépôt: 11.09.2003
(51) Int. Cl.: H01L 31/0203, H01L 25/04, H01L 27/146

(54) **DISPOSITIF DETECTEUR DE RAYONNEMENT ELECTROMAGNETIQUE AVEC BOITIER INTEGRE COMPORTANT DEUX DETECTEURS SUPERPOSES**
DETEKTOR FÜR ELEKTROMAGNETISCHE STRAHLUNG MIT INTEGRIERTEM GEHÄUSE, DER ZWEI ÜBERLAPPTE DETEKTOREN ENTHÄLT
ELECTROMAGNETIC RADIATION SENSING DEVICE WITH INTEGRATED HOUSING INCLUDING TWO SUPERIMPOSED SENSORS

(30) Priorité: 16.09.2002 FR 0211457
(43) Date de publication de la demande: 15.06.2005
(73) Titulaire: COMMISSARIAT A L'ENERGIE ATOMIQUE, 75752 Paris Cédex 15 (FR)
(72) Inventeur: OUVRIER-BUFFET, Jean-Louis, F-74320 Sévrier (FR); MOREL, Damien, F-38240 Meylan (FR); MASSONI, Nicolas, F-38000 Grenoble (FR)
(74) Mandataire: Jouvray, Marie-Andrée
(86) Numéro de dépôt international: PCT/FR2003/002696
(87) Numéro de publication internationale: WO 2004/025694

(56) Documents cités:
- US-A- 3 987 298
- US-A- 6 157 020
- US-B1- 6 320 189

## Description

### Domaine technique de l'invention

L'invention concerne un dispositif détecteur de rayonnement électromagnétique comportant deux détecteurs superposés, un premier détecteur non refroidi détectant une première gamme de longueurs d'onde, et un second détecteur non refroidi détectant une seconde gamme de longueurs d'onde.

### État de la technique

Les systèmes de détection multispectrale connus, c'est-à-dire capables de détecter plusieurs gammes de longueurs d'onde différentes, peuvent être juxtaposés ou superposés. Ainsi dans le domaine infrarouge, des systèmes multispectraux sont réalisés à partir d'un empilement de couches épitaxiales de CdₓHg₁₋ₓTe de composition variant avec x, elles mêmes épitaxiées sur un substrat transparent au rayonnement infrarouge. Les bandes d'absorption sont déterminées par la composition des couches détectrices. Les détecteurs réalisés dans ces couches sont de type photovoltaïque et fonctionnent à basse température, dans la gamme de longueurs d'onde comprise entre 1 et 12 microns environ, donc en dehors du spectre du rayonnement visible.

Dans le domaine infrarouge et visible, des systèmes de détection sont réalisés à partir de deux caméras qui explorent respectivement les bandes spectrales infrarouges et visibles. La caméra infrarouge, est constituée de détecteurs refroidis, réalisés en InSb ou en CdₓHg₁₋ₓTe, détectant respectivement la bande II et les bandes II et III dans le spectre infrarouge. La caméra visible peut être réalisée à partir d'un composant de type à couplage de charges (CCD).

D'autres systèmes utilisent la juxtaposition de détecteurs infrarouges refroidis en CdₓHg₁₋ₓTe et de détecteurs visibles en silicium. Le rayonnement provenant de la scène observée est alors scindé en deux faisceaux qui sont ensuite focalisés sur chaque type de détecteurs. Ces systèmes utilisent des détecteurs infrarouges refroidis, donc relativement coûteux et de mise en oeuvre complexe.

Le document US6107618 décrit un système multispectral comportant des détecteurs visibles et des détecteurs infrarouges qui peuvent être adjacents ou superposés.

Le document US6320189 décrit un appareil de détection multi-spectral infrarouge/visible utilisant un détecteur bolométrique et un photodétecteur superposés et combinés l'un à l'autre pour former un même élément sensible. Ainsi, l'appareil de détection comporte un micro-pont muni de piliers destinés à supporter des éléments actifs tels qu'un élément sensible aux radiations infrarouges et des électrodes, le micro-pont étant connecté à un circuit de multiplexage disposé sous le micro-pont et dans lequel peut être disposé le photodétecteur.

### Objet de l'invention

L'invention a pour but un dispositif détecteur ayant un faible encombrement et qui permet de détecter deux gammes de longueurs d'onde à partir d'un même faisceau incident, sans avoir à le séparer en deux faisceaux, tout en optimisant les performances des deux détecteurs.

Selon l'invention, ce but est atteint par le fait que le premier détecteur est disposé à l'intérieur d'un boîtier de protection étanche, au moins une paroi supérieure du boîtier de protection comportant le second détecteur.

Selon un premier développement de l'invention, les longueurs d'onde de la première gamme sont supérieures aux longueurs d'onde de la seconde gamme. Selon un second développement de l'invention, le boîtier comporte une base constituée par un circuit électronique de traitement, sur lequel est monté le premier détecteur.

Selon un mode de réalisation préférentiel, la première gamme de longueurs d'onde est comprise dans le domaine de l'infrarouge.

Selon une autre caractéristique de l'invention, la seconde gamme de longueurs d'onde est comprise dans le domaine du visible ou de l'ultraviolet.

Selon un autre mode de réalisation de l'invention, le dispositif détecteur comporte une pluralité de premiers détecteurs disposés à l'intérieur du même boîtier de protection. La paroi du boîtier de protection comporte, de préférence, une pluralité de zones réticulées et disposées au-dessus de chaque premier détecteur, de manière à ce que chaque zone réticulée comporte un second détecteur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 est une représentation schématique en coupe d'un détecteur infrarouge selon l'art antérieur.
Les figures 2 à 4 sont des représentations schématiques en coupe de plusieurs modes de réalisation d'un dispositif détecteur selon l'invention, comportant une photodiode visible.
La figure 5 est une représentation d'un mode de réalisation d'un phototransistor d'un dispositif détecteur selon l'invention.

### Description de modes particuliers de réalisation.

Le dispositif détecteur de rayonnement électromagnétique est réalisé avantageusement par des technologies utilisées dans le domaine de la microélectronique. Il comporte deux détecteurs superposés. Un premier détecteur non refroidi détecte une première gamme de longueurs d'onde et un second détecteur non refroidi détecte une seconde gamme de longueurs d'onde.

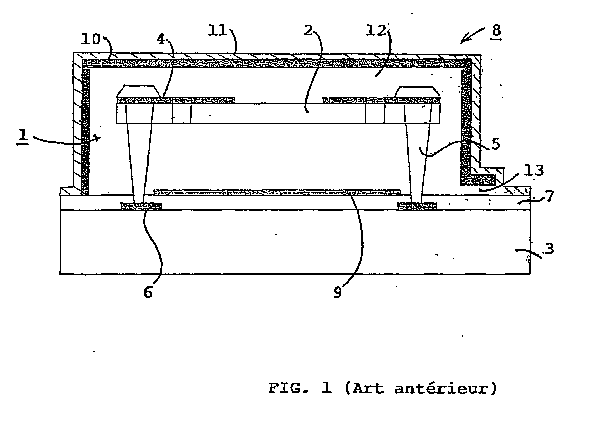

Le premier détecteur non refroidi détecte, de préférence, une première gamme de longueurs d'onde comprise dans le domaine de l'infrarouge. Le premier détecteur est disposé à l'intérieur d'un boîtier de protection. Il peut être, par exemple, constitué par un thermocouple, une diode ou, de préférence, un détecteur thermique non refroidi tel qu'un bolomètre de type connu, par exemple comme représenté à la figure 1.

Sur la figure 1, le bolomètre 1, fonctionnant à température ambiante, comporte au moins un élément sensible 2, sous forme de couche mince, connecté à un circuit électronique de traitement 3. Le circuit 3 peut être, par exemple, sous forme de couches minces en technologie silicium, de type CMOS ou CCD. Le circuit 3 et l'élément sensible 2 sont disposés parallèlement. L'élément sensible 2 est destiné à être chauffé par un rayonnement infrarouge compris dans la gamme de longueurs d'onde de 8µm à 14µm, ou de 3µm à 5µm, le rayonnement infrarouge étant caractéristique de la température et des propriétés émissives des corps observés par le dispositif détecteur.

L'augmentation de la température de l'élément sensible 2 engendre une variation d'une des propriétés électriques de l'élément sensible 2. Cette variation peut être, par exemple, une apparition de charges électriques par effet pyroélectrique, une variation de capacité par changement de la constante diélectrique ou une variation de la résistance de l'élément sensible s'il est semi-conducteur ou métallique.

L'élément sensible 2 doit présenter une faible masse calorifique et favoriser la conversion d'une variation thermique en une variation électrique.

L'élément sensible 2 peut être, par exemple, du silicium polycristallin ou amorphe, de type p ou n, ayant une résistivité faible ou forte, ou être sous la forme d'un oxyde de vanadium disposé dans une phase semi-conductrice. Pour un élément sensible métallique, il peut être, par exemple, en nickel, en nitrure de titane (TiN), en titane ou en platine. L'élément sensible 2 peut également être remplacé par une matrice d'éléments sensibles.

La variation de la propriété électrique de l'élément sensible 2 est mesurée par des électrodes 4. Les électrodes sont disposées sur la surface de l'élément sensible 2 qui forme un micro-pont entre des éléments de support 5. Les éléments de support 5, en forme de clous, constituent simultanément des éléments de connexion entre les électrodes 4 et le circuit électronique de traitement 3, de manière à permettre la mesure par le circuit 3 des propriétés électriques de l'élément sensible 2 entre les électrodes 4. Les éléments de support 5 sont reliés au circuit 3 par des connexions métalliques 6, disposées à l'interface du circuit et d'un support isolant 7, lui-même disposé sur la surface du circuit 3. Un réflecteur 9 peut être disposé sur le support isolant 7, de manière à réfléchir le rayonnement infrarouge vers l'élément sensible et assurer une détection maximale.

Pour améliorer les performances du bolomètre, il est connu de le disposer à l'intérieur d'un boîtier de protection 8 étanche, réalisant ainsi une micro-encapsulation, et de le maintenir sous vide ou sous un gaz peu conducteur de la chaleur. La base du boîtier de protection 8 est, de préférence, constituée par le circuit 3, sur lequel est monté le bolomètre 1. Le boîtier 8 comporte également, à sa partie supérieure, une fenêtre transparente à la gamme de longueurs d'onde détectée par le bolomètre.

Le boîtier de protection 8 peut être élaboré par les techniques usuelles de la microélectronique adaptée aux microtechnologies. Ainsi, une première couche 10, destinée à former le couvercle du boîtier de protection 8 et à délimiter une cavité 12 est déposée sur une couche sacrificielle, qui est ensuite retirée par gravure de manière à former la cavité 12. Un évent 13 est disposé entre le couvercle et la base du boîtier de protection 8, de manière à mettre le bolomètre sous une atmosphère contrôlée ou sous vide. Une couche de scellement 11 est déposée ultérieurement et sous vide sur la première couche 10, rendant la cavité 12 étanche.

Selon l'invention, au moins la paroi supérieure du boîtier de protection 8 du premier détecteur comporte le second détecteur 30, détectant une seconde gamme de longueurs d'onde. La paroi supérieure est, de préférence, elle-même constituée par le second détecteur. Les longueurs d'ondes de la première gamme détectée par le premier détecteur sont, de préférence, supérieures aux longueurs d'onde de la seconde gamme. La seconde gamme de longueurs d'onde est, de préférence, comprise dans le domaine du visible, de l'ultraviolet ou des rayons X et le second détecteur peut être, par exemple, un détecteur photovoltaïque, photoconducteur ou phototransistor.

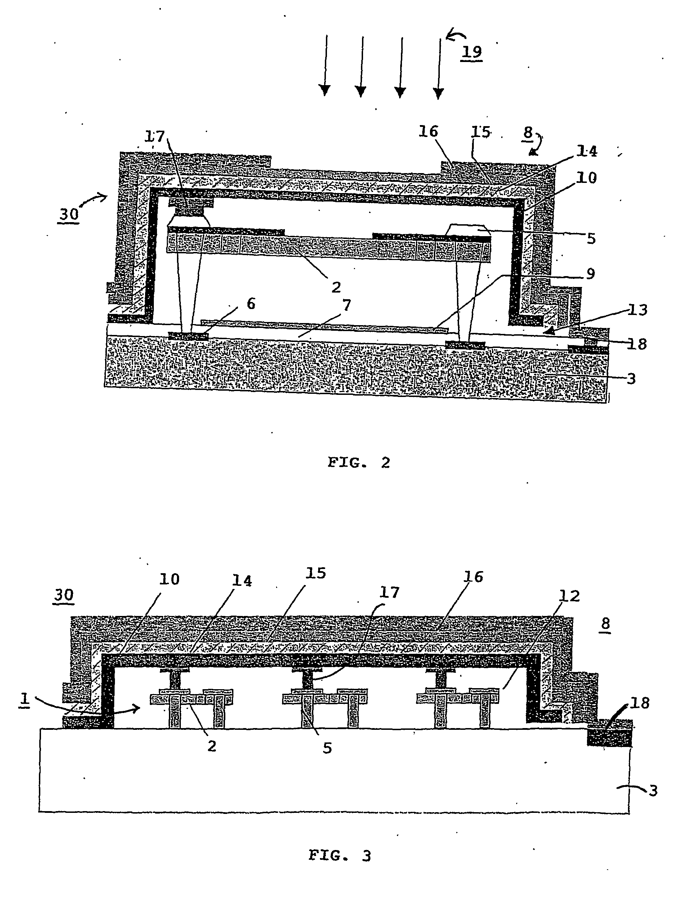

Selon un premier mode de réalisation représenté sur la figure 2, le second détecteur 30 est une photodiode de type pin ou nipdétectant les longueurs d'onde visibles. La photodiode constitue le couvercle du boîtier de protection 8 dont la base est constituée, par exemple, par le circuit électronique de traitement 3. Le second détecteur constitue alors les parois supérieure et latérales du boîtier de protection. Une première couche 10 du couvercle du boîtier 8 est une couche en matériau semi-conducteur dopé positivement (p) ou négativement (n). Elle est recouverte par une seconde couche intrinsèque (i) 14, elle même recouverte par une troisième couche 15 dopée soit n si la première couche 10 est dopée p, soit p si la première couche 10 est dopée n.

L'éclairement par un rayonnement visible génère, au sein de la photodiode, un nombre de porteurs proportionnel à l'énergie lumineuse absorbée par la photodiode, ce qui convertit la lumière absorbée en signaux électriques. Les signaux électriques sont ensuite mesurés par le circuit électronique de traitement 3, qui stocke et traite les signaux électriques. La connexion entre la photodiode et le circuit 3 est réalisée par deux électrodes.

Le premier contact ohmique de la photodiode est assuré par une électrode métallique 17 disposée entre la première couche 10 et un élément de support 5. L'élément de support 5 sert alors également d'élément de connexion entre la première couche 10 et le circuit électronique de traitement 3. Le second contact ohmique est réalisé par une électrode transparente 16 déposée sur une partie de la troisième couche 15, de manière à laisser une seconde partie supérieure de la couche 15 libre. L'électrode étant transparente, elle peut aussi recouvrir totalement la couche 15, ce qui n'est pas possible avec une électrode opaque, par exemple en aluminium. L'électrode transparente 16 est reliée au circuit électronique de traitement 3 par au moins un plot 18 assurant le contact électrique entre l'électrode et le circuit 3. Le plot 18 est disposé à l'interface de l'électrode transparente 16 et du circuit 3, dans la partie inférieure du boîtier 8. Le premier contact ohmique entre la couche 10 et le circuit 3, assuré par l'électrode métallique 17, peut aussi être pris directement sur le circuit 3 de la même manière que le second contact ohmique 18, au lieu de passer par l'élément de support 5.

Les couches 10 et 15 sont, de préférence, réalisées en a-Si :H ou en a-SiC :H, de type p ou n et ont une épaisseur comprise entre 0,01µm et 1µm. La couche 14 est réalisée en a-Si :H ou en a-SiGe :H, avec une épaisseur comprise entre 0,05µm et 5µm. L'électrode transparente 16 peut être réalisée par des oxydes conducteurs tels que ZnO, SnO₂ ou ITO (oxyde d'indium et d'étain ou « indium tin oxyde »), déposés par pulvérisation cathodique réactive. La photodiode de type pin peut être soit monochromatique soit polychromatique et peut être remplacée par une photodiode pn, à avalanche ou Schottky.

Le dispositif détecteur présente l'avantage de détecter deux gammes de longueurs d'onde différentes à partir d'un même faisceau incident, sans avoir à le séparer en deux faisceaux. La détection des deux gammes de longueurs d'onde s'effectue au niveau de l'élément sensible 2 pour la première gamme et au niveau du boîtier de protection pour la seconde gamme. Le matériau constituant le second détecteur absorbe totalement le rayonnement de la seconde gamme de longueurs d'onde, (visible dans le cas de la photodiode de type pin) mais transmet le rayonnement de la première gamme de longueurs d'onde (infrarouge dans le cas du bolomètre), ce qui entraîne une augmentation de la température, puis une variation d'une grandeur électrique de l'élément sensible 2.

Selon une variante de réalisation représentée sur la figure 3, le dispositif détecteur comporte une pluralité de premiers détecteurs disposés à l'intérieur du même boîtier de protection 8. Les premiers détecteurs sont des bolomètres 1 du type de ceux décrits ci-dessus et le couvercle du boîtier de protection est constitué par des photodiodes de type pin formant le second détecteur 30. Dans ce cas, l'électrode transparente 16 peut être commune à l'ensemble des photodiodes et est connectée au circuit 3 par un plot 18. La connexion entre la première couche 10 dopée p ou n et le circuit 3 est assurée par des électrodes métalliques 17 disposées sous la première couche 10 et reliées à chaque élément de support 5 de chaque premier détecteur. L'utilisation de microstructures en couche mince permet de réaliser une isolation thermique efficace des détecteurs bolométriques par rapport au circuit 3.

Le boîtier de protection 8 peut également comporter une pluralité de zones réticulées et disposées au-dessus de chaque premier détecteur, de manière à ce que chaque zone comporte un second détecteur. Ainsi soit la première couche 10 dopée p ou n, soit la troisième couche 15 dopée n ou p peut être gravée de manière à isoler les zones au-dessus de chaque premier détecteur et définir une photodiode de type pin ou nip au-dessus de chaque premier détecteur.

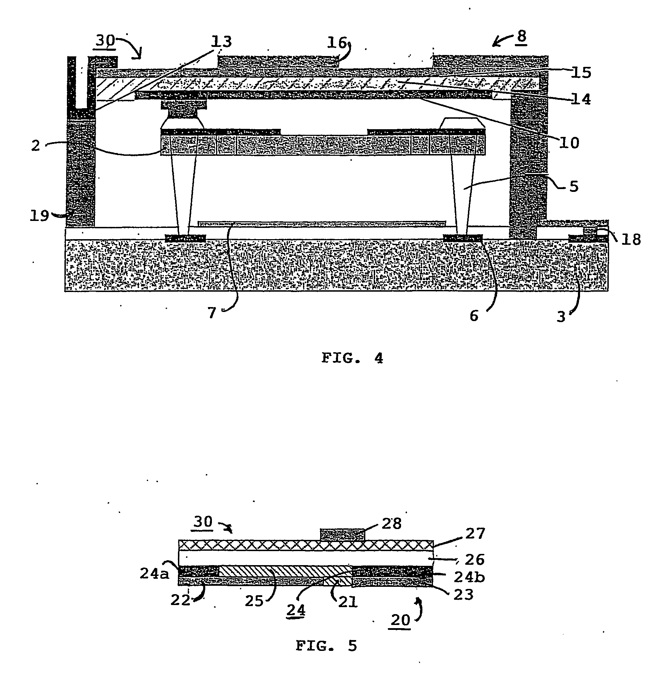

Dans un autre mode de réalisation représenté sur la figure 4, la (ou les) photodiode(s) de type pin constitue(nt) seulement la paroi supérieure, du boîtier de protection 8, opposée à la base qui est constituée par le circuit 3. Le boîtier comporte également des parois latérales 19, supportant la paroi supérieure et constituant, avec la photodiode, le couvercle du boîtier de protection 8. La première couche 10 de la photodiode peut être réticulée. Dans ce cas, l'évent 13 peut être disposé dans la partie supérieure du couvercle du boîtier de protection 8, comme représenté à la figure 4.

Le second détecteur 30 peut être également un (ou des) phototransistor(s) tel que celui représenté à la figure 5. Le phototransistor, détectant dans le domaine visible, comporte une première couche 20 métallique comportant une zone d'isolation 21 séparant la couche en deux parties, l'une formant une première zone de métallisation 22, tandis que l'autre forme une seconde zone de métallisation 23 isolée de la première zone 22. Une seconde couche 24 semi-conductrice dopée n+ en a-Si :H ou en a-SiC :H est disposée sur la première zone de métallisation 22 pour constituer la source 24a du phototransistor et sur la seconde zone de métallisation 23 pour constituer le drain 24b du phototransistor. Elle comporte une zone d'isolation 25 recouvrant la zone d'isolation 21 et une partie de la métallisation.

Une troisième couche 26 semi-conductrice en a-Si :H ou en a-SiGe :H, constituant une couche intrinsèque, recouvre la seconde couche 24. Une quatrième couche 27 isolante est disposée sur la troisième couche 26. La quatrième couche 27 est destinée à isoler la troisième couche 26 d'une grille 28 disposée sur une partie de la quatrième couche 27 et réalisée en matériau conducteur et transparent à la seconde gamme de longueurs d'onde.

Le drain 24b et la source 24a du transistor sont connectés à des éléments de support 5, qui polarisent ainsi à la fois le phototransistor et l'élément sensible 2 du bolomètre 1. L'épaisseur de la seconde couche 24 est comprise entre 0,01µm et 1µm, tandis que la troisième couche 26 a une épaisseur d'environ 0,05µm, pour une détection de rayonnement visible ou ultraviolet. Pour une détection de rayons X, le matériau formant la couche intrinsèque 26, par exemple le CdTe, a une épaisseur de l'ordre de quelques centaines de µm.

Selon un mode de réalisation particulier, les étapes de réalisation d'un dispositif détecteur selon l'invention sont les suivantes :
- Réalisation d'au moins un élément sensible ou micro-pont de micro-bolomètre sur une première couche sacrificielle, par exemple en polyimide, d'épaisseur comprise entre 1µm et 5µm, cette épaisseur étant, de préférence, égale au quart de la longueur d'onde à détecter. Une pluralité d'éléments sensibles peut être réalisée de manière à former une matrice de détecteurs.
- Dépôt d'une seconde couche sacrificielle en polyimide d'épaisseur comprise entre 0,2µm et 5µm.
- Réalisation des éléments de support 5 et de connexion par les techniques usuelles de dépôt et de gravure. Ils assurent également la fonction de renfort dans le cadre de la protection collective d'une matrice d'éléments sensibles ou de plusieurs bolomètres. Les éléments de support 5, métalliques, de préférence choisis parmi le titane, le nitrure de titane, le platine, l'aluminium, l'or, le tungstène, le nickel et la chrome, sont constitués à partir de couches déposées par pulvérisation cathodique, par un procédé CVD ou par évaporation. La forme de ces éléments est ensuite obtenue par des procédés de gravure chimique, plasma ou par un procédé de dépôt localisé à l'aide de résine connu sous le terme anglo-saxon « lift off ».
- Gravure sèche de la totalité des première et seconde couches sacrificielles en périphérie de la matrice dans le cas d'un boîtier collectif ou du détecteur dans le cas d'un boîtier individuel. La gravure sèche peut être réalisée par un procédé de plasma à l'oxygène par radiofréquence ou micro-onde ou au moyen d'un ozoneur.
- Réalisation des dépôts des couches constituant les parois du boîtier de protection et un détecteur UV-Visible, tout en générant un évent. L'épaisseur des couches constituant les parois du boîtier de protection et du détecteur est comprise entre 0,01µm et 10µm. Les dépôts se font par un procédé de PECVD (« Plasma Enhanced Chemical Vapor Deposition »), par un procédé de pulvérisation ou au moyen d'un filament chaud.
- Gravure sèche à travers l'évent de la totalité des première et seconde couches restantes, à l'intérieur du boîtier de protection par les mêmes procédés que précédemment de manière à former la cavité 12.
- Dépôt de la couche étanche permettant d'effectuer le scellement de la cavité et contrôle simultané de l'atmosphère dans la cavité 12. Dans le mode de réalisation de la figure 2, cette couche est constituée par l'électrode transparente 16 et peut être en matériau métallique d'épaisseur comprise entre 0,5 µm et 5µm. Il peut également s'agir de couches antireflet déposées par évaporation ou pulvérisation.
- Réalisation éventuelle d'un dépôt antireflet supplémentaire.
- Séparation des dispositifs par les techniques usuelles de découpe.

L'invention n'est pas limitée aux modes de réalisation ci-dessus. Ainsi les premier et second détecteurs peuvent aussi être réalisés sous forme de barrettes comportant plusieurs détecteurs disposés côte à côte ou sous forme de réseau bidimensionnel ou mosaïque.

## Revendications

1. Dispositif détecteur de rayonnement électromagnétique comportant deux détecteurs superposés, un premier détecteur non refroidi détectant une première gamme de longueurs d'onde, et un second détecteur (30) non refroidi détectant une seconde gamme de longueurs d'onde, dispositif **caractérisé en ce que** le premier détecteur est disposé à l'intérieur d'un boîtier de protection (8) étanche, au moins une paroi supérieure du boîtier de protection (8) comportant le second détecteur (30).

2. Dispositif détecteur selon la revendication 1, **caractérisé en ce que** les longueurs d'onde de la première gamme sont supérieures aux longueurs d'onde de la seconde gamme.

3. Dispositif détecteur selon l'une des revendications 1 et 2, **caractérisé en ce que** le boîtier (8) comporte une base constituée par un circuit électronique de traitement (3), sur lequel est monté le premier détecteur.

4. Dispositif détecteur selon la revendication 3, **caractérisé en ce qu'**il comporte des éléments de connexion électrique entre le second détecteur et le circuit (3).

5. Dispositif détecteur selon la revendication 4, **caractérisé en ce qu'**il comporte des éléments de support (5) du premier détecteur constituant des éléments de connexion électrique entre le premier détecteur et/ou le second détecteur (30) et le circuit électronique de traitement (3).

6. Dispositif détecteur selon l'une quelconque des revendications 1 à 5, **caractérisé en ce qu'**au moins la paroi supérieure du boîtier de protection (8) est constituée par le second détecteur (30).

7. Dispositif détecteur selon la revendication 6, **caractérisé en ce que** le second détecteur constitue les parois supérieure et latérales du boîtier de protection (8).

8. Dispositif détecteur selon l'une quelconque des revendications 1 à 7, **caractérisé en ce que** la première gamme de longueurs d'onde est comprise dans le domaine de l'infrarouge.

9. Dispositif détecteur selon la revendication 8, **caractérisé en ce que** le premier détecteur est un bolomètre (1), un thermocouple ou une diode.

10. Dispositif détecteur selon l'une quelconque des revendications 1 à 9, **caractérisé en ce que** la seconde gamme de longueurs d'onde est comprise dans le domaine du visible ou de l'ultraviolet.

11. Dispositif détecteur selon la revendication 10, **caractérisé en ce que** le second détecteur (30) est un détecteur photovoltaïque, photoconducteur ou phototransistor.

12. Dispositif détecteur selon l'une quelconque des revendications 1 à 9, **caractérisé en ce que** la seconde gamme de longueurs d'onde est comprise dans le domaine des rayons X.

13. Dispositif détecteur selon l'une quelconque des revendications 1 à 12, **caractérisé en ce qu'**il comporte une pluralité de premiers détecteurs disposés à l'intérieur du même boîtier de protection (8).

14. Dispositif détecteur selon la revendication 13, **caractérisé en ce que** la paroi du boîtier de protection (8) comporte une pluralité de zones réticulées et disposées au-dessus de chaque premier détecteur, de manière à ce que chaque zone réticulée comporte un second détecteur (30).

## Claims

1. Electromagnetic radiation detection device comprising two superposed detectors, a first non-cooled detector detecting a first range of wavelengths and a second non-cooled detector (30) detecting a second range of wavelengths, device **characterized in that** the first detector is arranged inside a tightly sealed protective housing (8), at least a top wall of the protective housing (8) comprising the second detector (30).

2. Detection device according to claim 1, **characterized in that** the wavelengths of the first range are higher than the wavelengths of the second range.

3. Detection device according to one of the claims 1 and 2, **characterized in that** the housing (8) comprises a base formed by an electronic processing circuit (3), whereon the first detector is mounted.

4. Detection device according to claim 3, **characterized in that** it comprises electrical connection elements between the second detector and the circuit (3).

5. Detection device according to claim 4, **characterized in that** it comprises support elements (5) of the first detector constituting electrical connection elements between the first detector and/or the second detector (30) and the electronic processing circuit (3).

6. Detection device according to any one of the claims 1 to 5, **characterized in that** at least the top wall of the protective housing (8) is formed by the second detector (30).

7. Detection device according to claim 6, **characterized in that** the second detector (30) forms the top and side walls of the protective housing (8).

8. Detection device according to any one of the claims 1 to 7, **characterized in that** the first range of wavelengths is comprised in the infrared range.

9. Detection device according to claim 8, **characterized in that** the first detector is a bolometer (1), a thermocouple or a diode.

10. Detection device according to any one of the claims 1 to 9, **characterized in that** the second range of wavelengths is comprised in the visible or ultraviolet range.

11. Detection device according to claim 10, **characterized in that** the second detector (30) is a photovoltaic, photoconductive or phototransistor detector.

12. Detection device according to any ane of the claims 1 to 9, **characterized in that** the second range of wavelengths is comprised in the X-ray range.

13. Detection device according to any one of the claims 1 to 12, **characterized in that** it comprises a plurality of first detectors arranged inside the same protective housing (8).

14. Detection device according to claim 13, **characterized in that** the wall of the protective housing (8) comprises a plurality of reticulated zones arranged above each first detector, so that each reticulated zone comprises a second detector (30).

## Patentansprüche

1. Messfühleranordnung zur Erfassung elektromechanischer Strahlung mit zwei übereinander angeordneten Messfühlern, und zwar einem ersten, nicht gekühlten Messfühler, der einen ersten Wellenlängenbereich erfasst, und einem zweiten, nicht gekühlten Messfühler (30), der einen zweiten Wellenlängenbereich erfasst, Anordnung, die **dadurch gekennzeichnet ist, dass** der erste Messfühler Innerhalb eines dichten Schutzgehäuses (8) angeordnet ist, wobei mindestens eine obere Wand des Schutzgehäuses (8) den zweiten Messfühler (30) umfasst.

2. Messfühleranordnung nach Anspruch 1, **dadurch gekennzeichnet, dass** die Wellenlängen des ersten Bereichs größer sind als diejenigen des zweiten Bereichs.

3. Messfühleranordnung nach einem der Ansprüche 1 und 2, **dadurch gekennzeichnet, dass** das Gehäuse (8) eine Basis umfasst, die von einer elektronischen Verarbeitungsschaltung (3) gebildet wird, auf der der erste Messfühler montiert ist.

4. Messfühleranordnung nach Anspruch 3, **dadurch gekennzeichnet, dass** sie Elemente zur elektrischen Verbindung zwischen dem zweiten Messfühler und der Schaltung (3) umfasst.

5. Messfühleranordnung nach Anspruch 4, **dadurch gekennzeichnet, dass** sie Stützelemente (5) für den ersten Messfühler umfasst, die Elektroverbindungselemente zwischen dem ersten Messfühler und/oder dem zweiten Messfühler (30) und der elektronischen Verarbeitungsschaltung (3) bilden.

6. Messfühleranordnung nach einem der Ansprüche 1 bis 5, **dadurch gekennzeichnet, dass** mindestens die obere Wand des Schutzgehäuses (8) von dem zweiten Messfühler (30) gebildet wird.

7. Messfühleranordnung nach Anspruch 6, **dadurch gekennzeichnet, dass** der zweite Messfühler die obere Wand und die Seitenwände des Schutzgehäuses (8) bildet,

8. Messfühleranordnung nach einem der Ansprüche 1 bis 7, **dadurch gekennzeichnet, dass** der erste Wellenlängenbereich Im Infrarotbereich liegt.

9. Messfühleranordnung nach Anspruch 8, **dadurch gekennzeichnet, dass** der erste Messfühler ein Bolometer (1), ein Thermoelement oder eine Diode ist.

10. Messfühleranordnung nach einem der Ansprüche 1 bis 9, **dadurch gekennzeichnet, dass** der zweite Wellenlängenbereich im sichtbaren oder Ultraviolettbereich liegt.

11. Messfühleranordnung nach Anspruch 10, **dadurch gekennzeichnet, dass** der zweite Messfühler (30) ein Fotovoltaik-, Fotoleiter- oder Fototransistor-Messfühler ist.

12. Messfühieranordnung nach einem der Ansprüche 1 bis 9, **dadurch gekennzeichnet, dass** der zweite Wellenlängenbereich im Röntgenstrahlenberelch liegt.

13. Messfühleranordnung nach einem der Ansprüche 1 bis 12, **dadurch gekennzeichnet, dass** sie mehrere erste Messfühler umfasst, die In ein und demselben Schutzgehäuse (8) angeordnet sind.

14. Messfühleranordnung nach Anspruch 13, **dadurch gekennzeichnet, dass** die Wand des Schutzgehäuses (8) mehrere Bereiche aufweist, die vernetzt sind und über jedem ersten Messfühler angeordnet sind, damit jeder vernetzte Bereich einen zweiten Messfühler (30) umfasst.
